# EUROPEAN PATENT APPLICATION

(11) **EP 1 311 091 A1**
(43) Date of publication of application: **14.05.2003**
(21) Application number: 01440376.0
(22) Date of filing: 09.11.2001
(51) Int. Cl.: H04L 12/56, H03M 13/03, H04L 1/02

(54) **Method for transporting real-time data frames comprising at least two bit portions having different relevance; corresponding transmitter and receiver**

(71) Applicant: Evolium S.A.S., 75008 Paris (FR)
(72) Inventor: Paul, Nicolas, 75002 Paris (FR); Thirouard, Carine, 91190 Gif sur Yvettte (FR); Brouet, Jèrôme, 75014 Paris (FR)
(74) Representative: Urlichs, Stefan, Dipl.-Phys.

(57) **Abstract**

The present invention relates to a method for transporting real-time data from a transmitter to a receiver on a radio packet communication network, the real time data entity being generated at the transmitter and comprising at least two bit portions having different relevance, each real time data entities being encapsulated in a radio block and submitted to a modulation and coding scheme (M, C) before transmission.

According to the present invention, at least one portion of a real-time data frame is repeated in several radio blocks to create redundancy. This redundancy compensates for a low efficient Modulation and Coding Scheme especially for the bit portions of the real-time data entity having the highest relevance (class A bits).

At the receiver side, the different copies of the repeated bit portion are extracted from the received radio blocks and processed in order to eliminate the transmission errors.

## Description

### BACKGROUND OF THE INVENTION

The present invention relates to radio packet communication networks and more precisely to a method for transporting real-time data such as compressed voice or compressed video in such networks.

Radio packet communication networks, such as GPRS (General Packet Data Services) or EDGE (Enhanced Data rate for GSM Evolution) networks, at the origin thought for the transmission of pure data, have been adapted to the transmission of real time services as voice services.

In radio packet communications networks, no physical connection is established for the whole duration of the conversation as in circuit oriented radio communication network as GSM, where fixed time slots are allocated in each frame for each user.

On the contrary, in radio packet communications networks, specific medium access mechanisms control dynamically the allocation of resource (i.e. time slot in a frame and frequency) to the different users depending on their needs.

This presents the advantage of a higher network capacity. Indeed, when users have nothing to transmit other users can be allocated the transmission medium. On the other hand, however, specific additional features must be implemented to comply with the specificity of voice and video services.

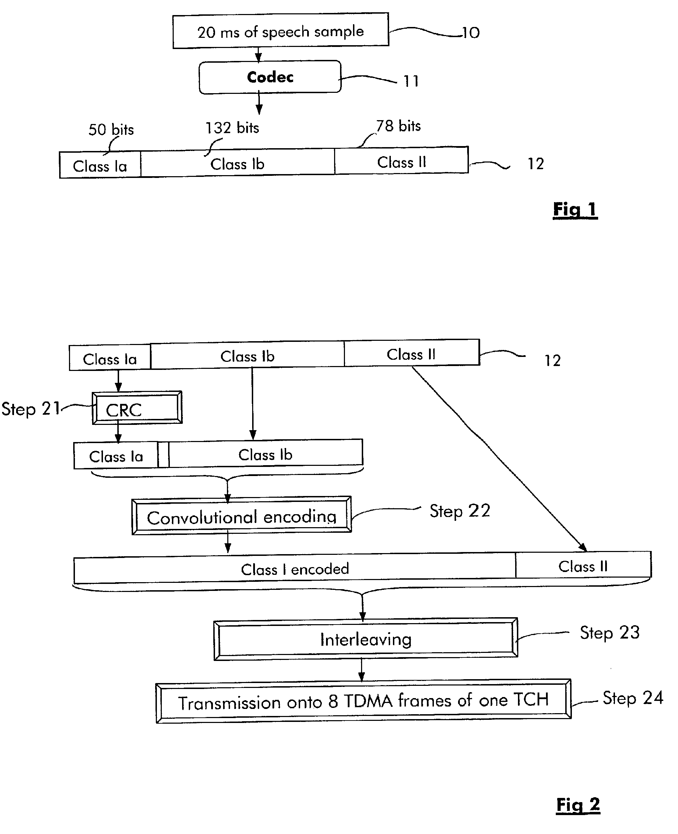

One of this specificity consists in that the voice frame at the output of a voice codec comprises bits having different relevance. As shown on figure 1, a 20 ms speech sample 10 is encoded by using a voice codec 11 usually a GSM full rate codec (13Kbps) compliant with the specification GSM TS 06.10. A voice frame 12 is obtained at the output of codec 11 and comprises 260 bits divided in three bit portions 50 class A bits, 132 class B bits and 78 class C bits. The different bit portions are also referred to as Class Ia, Class Ib and Class II respectively in the GSM context. Class A and B bits are the most relevant bits describing the voice frame. The correct reception of class A bits is essential to reconstruct the voice frame at the receiver side while errors on class B and class C bits can be tolerated.

A solution implemented in usual GSM circuit oriented networks is presented on figure 2. It takes into account the different relevance of the different class of bits, while not increasing too much the redundancy, and consists in applying unequal error protections to the different portions class A, Class B, Class C of the voice frame 12. Unequal error protection consists in protecting more the class A and B than the class C bits. The class A and B bits as for this purpose submitted to a convolutional encoding (step 22) while the class C are sent without any protection. To protect class A bits even more and ensure error detection at the receiver in case of propagation errors on the radio link, a checksum CRC is appended (step 21) at the end of the class A bits. Then, interleaving (step 23) is performed to maximize to decoding capability on the convolutional decoder at the receiver side and the resulting TDMA frames are modulated and transmitted on a radio communication channel (step 24) i.e. a traffic channel TCH.

This solution is however not applicable to radio packet communication networks as GPRS or EDGE designed for the transport of data where each bit has similar importance. Hence, on a packet radio channel of such radio packet communication network, each bit is equally protected. As a consequence, class A bits are not enough protected while Class C bits are over protected. This, has the disadvantage to cause a degradation of the voice quality in such radio packet communication networks. If a protection adapted to the requirements of class A bits is used for the whole voice frame, the voice quality will be ensured but the redundancy due to the high overhead of the protection will cause very poor performance of the system.

Some solutions to this problem consist in developing new modulation and coding schemes more efficient than the ones already specified for the radio packet communication network. A example of a new modulation and coding scheme is given in the article "Transmission of voice in an EDGE Network" Wu and al, from the Bell Labs which should be added to the nine already defined modulation and coding schemes of EDGE.

A particular object of the present invention is to provide an alternative method for transporting of real-time data (e.g. voice, video) in a radio packet communication with a good quality while optimizing the performances of the system in terms of data redundancy.

Another object of the invention is to provide a transmitter of a radio packet communication network implementing a such method and a receiver adapted to receive signal transmitted according to the present invention.

### SUMMARY OF THE INVENTION

These objects, and others that appear below, are achieved by a method for transporting real-time data from a transmitter to a receiver on a radio packet communication network according to claim 1, a transmitter according to claim 7 and a receiver according to claim 8.

According to the present invention, at least one portion of a real-time data frame is repeated in several radio blocks to create redundancy. This redundancy compensates for a low efficient Modulation and Coding Scheme especially for the bit portions of the real-time data entity having the highest relevance (class A bits).

At the receiver side, the different copies of the repeated bit portion are extracted from the received radio blocks and processed in order to eliminate the transmission errors.

The method according to the present invention presents the advantage to increase the quality of the transmitted real-time data while not overprotecting the less relevant bits. Indeed, a modulation and coding scheme having an average error-resistance will be used. To ensure a good error protection for higher relevant bit portions, these bit portions are repeated in several radio blocks. The errors are corrected in these higher relevant bit portions by combining the different copies of the same bit portion.

The method according to the present invention presents further the advantage to reuse usual modulation and coding schemes already defined in the radio packet communication network standard.

In a preferred embodiment of the present invention, orthogonal puncturing schemes are applied to the radio blocks comprising the repeated bit portion of the real-time data entity.

Further advantageous features of the invention are defined in the dependent claims.

### BRIEF DESCRIPTION OF THE DRAWINGS

Other characteristics and advantages of the invention will appear on reading the following description of a preferred embodiment given by way of non-limiting illustrations, and from the accompanying drawings, in which:
- Figure 1 shows a usual method for coding speech samples with a voice codec and the format of the corresponding voice frame at the output of the codec;
- Figure 2 shows a prior art method used for transporting compressed voice in a circuit-oriented radio communication network using unequal error protection;
- Figure 3 illustrates an embodiment of the method for transporting real-time data in a radio packet communication network at the transmitter side according to the present invention;
- Figure 4 illustrates an embodiment of the method according to the present invention at the receiver side;
- Figure 5 represents an embodiment of a transmitter according to the present invention;
- Figure 6 represents an embodiment of a receiver according to the present invention.

### DETAILED DESCRIPTION OF THE INVENTION

Figure 1 and figure 2 have already been described in connection with prior art.

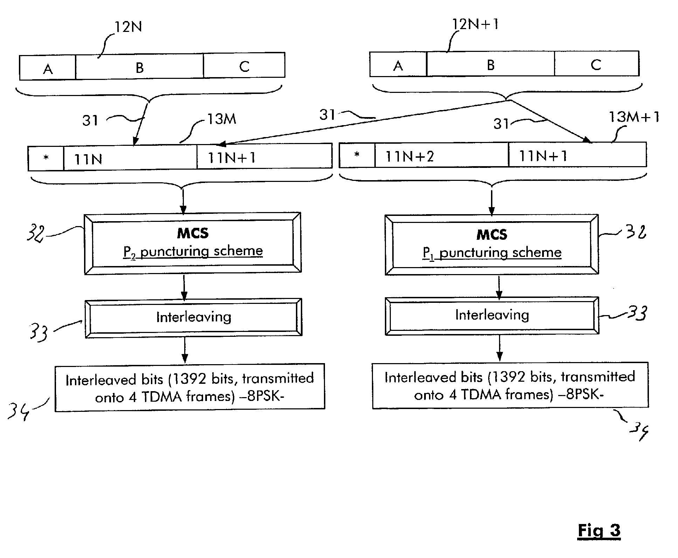

Figure 3 illustrates an embodiment of the method according to the present invention as performed at the transmitter side.

In this embodiment real-time data entities consists in compressed voice, obtained as already described on figure 1. The invention is, however, not limited to the use of the method in the case of voice frames presenting three different bit portions obtained with a full rate GSM codec. It will be clear for a person skilled in the art that the embodiment of the invention described below can be applied in further cases as for example for voice frames obtained with an half rate codec or for transporting video data also coded so as to present several bit portions with different relevance. Such a codec for video can for example be compliant with the MPEG 4 format.

Figure 3 represents two successive voice frame 12N, 12N+1 comprising three bit portions Class A, Class B, Class C.

Step 31 consists in encapsulating each voice frame 12N, 12N+1 in two radio blocks. Figure 3 shows this mechanism for voice frame 12N+1 which is repeated in radio blocks 13M and 13M+1.

In another embodiment of the present invention, only class A bit portions of the voice frames 12N, 12N+1 having the highest relevance may be repeated in the consecutive frame. Moreover, for a higher redundancy, the repetition can be done in more than two consecutive frames. It will be clear for a person skilled in the art that such variations as to the size of the repeated bit portions and the number of repetitions are covered by the present invention.

The repeated voice frames may be encapsulated in consecutive radio blocks. However, they may be as well encapsulated in non-consecutive radio blocks, a predefined function determining the radio blocks in which the repeated voice frames or parts of it have to be repeated.

Step 32 consists in encoding and modulating the radio blocks 13M,13M+1 with a modulation and coding scheme characterized respectively by their coding rate and modulation efficiency.

The coding rate of a coding scheme corresponds to the ratio between the number of bits at the input of the encoder and the number of bits at the output of the encoder. A coding scheme with a low coding rate generate a high overhead in the coded data and is as a consequence more error-resistant than a coding scheme with a higher coding rate. Preferably, convolutional encoding is used.

The modulation efficiency of a modulation scheme correspond to the number of data bit per modulation symbols. The higher the number of bits per modulation symbol, the more efficient the modulation. Indeed, a modulation with a low efficiency will be used to modulate bit portions which need to be very error-resistant as class A bits for example.

In a preferred embodiment of the invention, the modulation and coding scheme is chosen out of a group of modulation and coding schemes defined in the GPRS or EDGE network specification.

A couple modulation scheme / coding scheme determine the maximum efficient data rate which can be transmitted on a radio channel. Also defined in the EDGE GPRS network specification is the length of the radio block corresponding to each defined modulation and coding scheme.

Such couples modulation scheme /coding scheme (MCS) are defined in the specification of the EDGE radio packet communication network. They are presented in the following table by increasing error-resistance.

| | Modulatio n scheme | Coding rate | Max eff. bit rate Kbit/s | Radio block length bits |
|---|---|---|---|---|
| MCS9 | 8PSK | 1 | 59.2 | 1184 |
| MCS8 | 8PSK | 0.92 | 54.4 | 1088 |
| MCS7 | 8PSK | 0.76 | 44.8 | 896 |
| MCS6 | 8PSK | 0.49 | 29.6 | 592 |
| MCS5 | 8PSK | 0.37 | 22.4 | 448 |
| MCS4 | GMSK | 1 | 17.6 | 352 |
| MCS3 | GMSK | 0.8 | 14.8 | 296 |
| MCS2 | GMSK | 0.66 | 11.2 | 224 |
| MCS1 | GMSK | 0.53 | 8.8 | 176 |

In the framework of EDGE, the size of a radio block is directly dependent on the chosen modulation and coding scheme.

In order for the transporting method to work properly, one radio block should be large enough to encapsulate one real time data entity plus the whole redundancy related to one data entity.

For example, if the redundancy consists in repeating the whole real-time data entity, the radio block should be able to contain at least two real-time data entities. In the framework of EDGE, only the modulation and coding schemes MCS6 and higher fulfil this condition. As a consequence, one of these modulation and coding schemes should be selected.

In a preferred embodiment, step 32 comprises also a step of puncturing of the encoded symbols before modulation. Puncturing consists in suppressing predefined bits from the data to transmit in order to reduce the number of bits to transmit. The suppressed bits are reconstructed at the receiver which has the knowledge of the puncturing scheme used. An example of puncturing scheme consists in suppressing one bit every three bits (i.e. bit 1 bit 4, bit 7 and so on , such a puncturing scheme has a puncturing rate of 1/3).

In the framework of the present invention, it is preferable, when using puncturing, to use orthogonal puncturing schemes for radio blocks comprising different version of one real-time data entity or portions of it, in order not to suppress the same bits in the repeated bit portions. Orthogonal puncturing schemes, means that the puncturing rate is the same but the suppressed bit are positioned at different locations in the data to puncture (i.e. puncturing scheme P1 consists in suppressing bit 1, bit 4, bit 7 a.s.o., while orthogonal puncturing scheme P2 consists in suppressing bit 2, bit 5, bit 8 a.s.o.).

Step 33 consists in interleaving the radio blocks after encoding and modulation. This step is however not mandatory in the framework of the present invention but has the advantage of maximizing the encoding capability of the decoder at the receiver side.

Step 34 consists in transmitting the interleaved bits on a radio link preferably onto 4 TDMA frames in the case this invention is applied to EDGE transmission network.

An optional step not represented on figure 3 would first consists in appending a checksum to the class A bit portion of voice frames 12N, 12N+1 to increase the error protection of the high relevant class A bit portion. The checksum may correspond to any well-known Cyclic Redundancy Check mechanism. This step should be performed before step 31.

In the embodiment described above the used modulation and coding scheme was fixed determined in order for the source bit rate (i.e. bit rate of the voice frame issued at the codec) to be lower or equal to the channel bit rate (i.e. the efficient bit rate on the radio link). This is mandatory in order to respect the real time character of the voice frame. If this condition were not fulfilled, irrecoverable delay would be introduced in the voice frame transmission.

In a preferred embodiment of the present invention, a further step consisting in selecting a modulation and coding scheme could be performed before step 31. This selection would preferably depend on an indicator of the radio link quality. Indeed, if the radio link quality is good, a lower error protection is necessary. As a consequence, the redundancy can be reduced in that the size of the repeated bit portions may be reduced or the number of repetitions may be reduced. On the contrary, for bad radio link quality, the error protection should be increased in that the redundancy is also increased. When increasing the redundancy, the condition to have a source bit rate lower than the channel bit rate implies the selection of a modulation and coding scheme having higher coding rate and/or a higher modulation efficiency.

The change of amount of redundancy and modulation and coding scheme depending on an indicator of the radio link quality should be agreed upon at the transmitter and at the receiver.

The following example shows two redundancy policies:
- Policy 1 for good radio link quality: repeat class A bit portion once.
- Policy 2 for bad radio link quality: repeat class A bit portion twice and class B bit portion once.
For this purpose, any indicator of the radio link quality may be used: for example the Signal to Interference ratio.

The present invention may be used in TDMA(Time Division Multiple Access)-based radio packet communication systems as EDGE but is not limited to those. The present invention may also be used in CDMA (Code Division Multiple Access)-based as well as on OFDM (Orthogonal Frequency Division Multiplexing)-based wireless communication systems or any other radio packet communication systems when transmitting real-time data as compressed voice or compressed video.

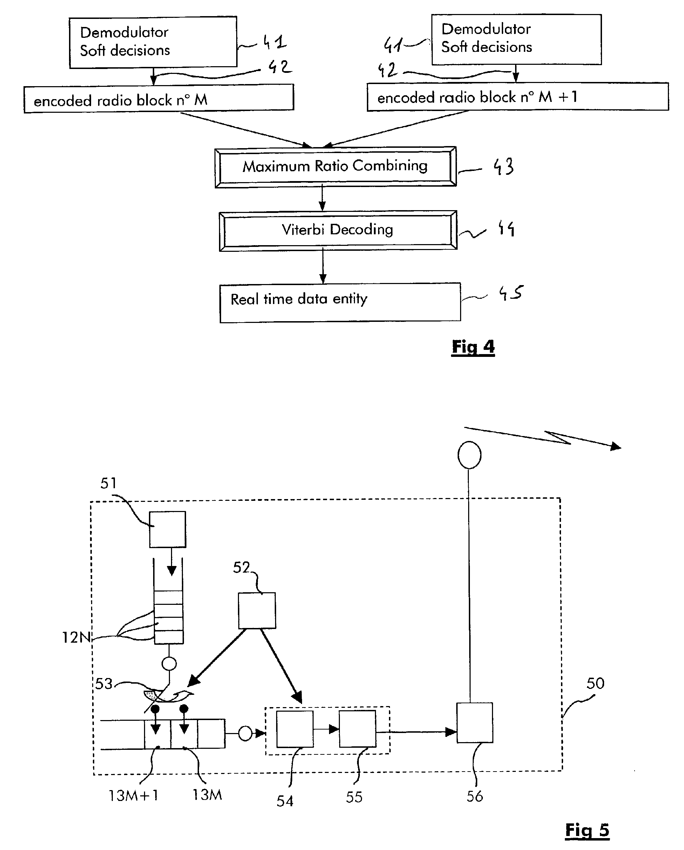

Figure 4 represents an embodiment of the method according to the present invention at the receiver side.

Step 41 consists in performing demodulation with soft decision outputs to obtain encoded radio blocks.

Step 42 consists in extracting from at least two radio blocks different copies of the repeated real-time data entity or the bit portion of which.

Step 43 consists in applying a predefined function to the different copies of the repeated real-time data entity or of the repeated bit portion of which in order to correct transmission errors by taking advantage of the redundancy. A preferable predefined function consists in maximum ratio combining of the repeated bit portions.

Maximum ratio combining is a known algorithm which can be applied when several versions of an identical quantity to estimate are available. The algorithm consists in calculating a linear combination of the different versions of the quantity to estimate. The weighting coefficient associated to one version of the quantity to estimate corresponds to its reliability. Maximum ratio combining is applied to each bit of the repeated real-time data entity or to the repeated portion of which, the reliability of one bit being equal to the absolute value of the soft decision at the output of the demodulator.

If a puncturing scheme is used at transmission, the decoder should replace the punctured bits by zeros.

Step 44 consists in decoding the radio block preferably with a Viterbi decoder.

Step 45 consists in retrieving the real-time data entity free from transmission errors.

Figure 5 represents an embodiment of a transmitter 50 according to the present invention to be used in a radio packet communication network. Transmitter 50 comprises a codec 51, means for selecting a modulation and coding scheme 52, means 53 for repeating at least one portion of each real-time data entity generated by codec 51 in at least one additional radio blocks, an encoder 54, a modulator 55, and a transmission module 56.

Codec 51 is preferably GSM full-rate codec encoding speech sample in voice frames comprising at least two bit portions of different relevance.

Means for selecting a modulation and coding scheme 52 determine out of a group of available modulation and coding scheme which one is the best suited for the transmission of real time data entities according to the present invention. This selection depends on the amount of redundancy that should be added to the real-time data entity (i.e. which bit portion(s) of the real-time data entity should be repeated and how many times). Means for selecting a modulation and coding scheme preferably add the real-time data entity length with the length of all bit portions which have to be repeated in consecutive frames. This total length should be smaller or equal to the length of the radio block payload, where these information will be encapsulated. The minimum length of a radio block determined the appropriate modulation and coding schemes.

In a first embodiment, the whole real-time data entity is repeated once as shown on figure 3. If the real-time data entity length equals 260 bits, the radio block should at least be able to encapsulate 520 payload bits. In EDGE specification the first modulation and coding scheme fulfilling this condition is MCS 6 with a payload of 592 bits.

In a second embodiment, only the class A bits of the real-time data entity are repeated once. The class la length is 50 bits. Then the radio block should be able to encapsulate one whole real-time data entity plus one class la bit portion equals 310 bits. According to EDGE specification, MCS4 with a radio block payload of 252 bits is the first modulation which fulfils this condition.

For any other embodiment of the present invention, the way of selecting an appropriate MCS should be done the same way.

Means 52 for selecting a modulation and coding scheme are not mandatory in the framework of the present invention. The use of a fixed MCS may be hard-coded in the transmitter. Means 52 for selecting a modulation and coding scheme are advantageous in combination with a radio link quality estimator (not represented). In this case, the used modulation and coding scheme may be modified according to the current radio link quality. A threshold may be defined to determine up to which radio link quality which modulation and coding schemes are used for which bit portions.

Once the used MCS and the corresponding radio block format has been chosen, means 53 are responsible for filling in the radio blocks according to the method according to the present invention. Means 53 repeats the real-time data entity or the bit portion of which at a predefined location in at least one additional radio block.

Transmitter 50 further comprises an encoder 54, preferably a convolutional encoder, followed by a modulator 55 implementing the selected modulation and coding scheme. In a preferred embodiment, transmitter 50 further comprises a module for performing puncturing (not represented) located between encoder 54 and modulator 56.

Eventually, transmitter 50 comprises a transmission module 56 for transmitting the encoded and modulated radio block on the air interface.

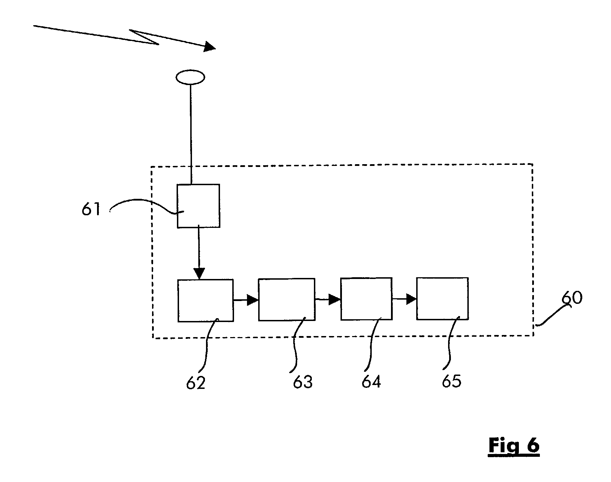

Figure 6 represents an embodiment of a receiver 60 according to the present invention to be used in a radio packet communication network. Receiver 60 comprises a module 61 for receiving data signals, a demodulator 62, a decoder 63, preferably a Viterbi decoder, a module 64 for extracting different versions of the same real-time data entity or a bit portion of which from at least two consecutive radio blocks, and a module 65 for correcting errors in the received real time-radio block or the bit portion of which. Module 65 for correcting errors preferably implements a maximum ratio combining algorithm.

In order for a system comprising a plurality of transmitters and receiver according to the present invention to work efficiently, the voice frame format delivered by the codecs 51 must be known at both the transmitter 50 and the receiver 60. As well, the used modulation and coding scheme, the puncturing scheme and the format of the radio block contents should be known at both transmitter 50 and receiver 60 either in that they are hard coded at the transmitter and at the receiver or in a preferred embodiment in that they are agreed upon between the transmitter and the receiver in a setup phase.

In a further embodiment of the present invention, these parameters may also be updated dynamically depending on the current propagation conditions on the radio link. This change would according to the present invention necessitate the change of radio block format each time the modulation and coding schemes are modified to fit the radio link quality.

## Claims

1. Method for transporting real-time data entities (12N) from a transmitter to a receiver on a radio packet communication network, said real time data entities (12N) being generated at said transmitter and comprising at least two bit portions (class A, class B) having different relevance, each of said real time data entities (12N) being encapsulated in a radio block (13M) and submitted to a modulation and coding scheme (MCS) before transmission, said method being **characterized in that** it comprises the steps of:
i. repeating at least one bit portion (class A) of said real time data entity (12N) in at least one additional radio block (13M+1); and
ii. extracting, at the receiver side, different copies of said at least one repeated bit portion (class A) of a real-time data entity (12N) from at least two received radio blocks (13M,13M+1); and
iii. correcting errors in said at least one bit portion at said receiver by applying a predefined function to said repeated bit portions received in said at least two radio blocks.

2. Method according to claim 1, **characterized in that** said predefined function consists in maximal ratio combining of said different repeated bit portions.

3. Method according to claim 1, **characterized in that** it further comprises the step of applying orthogonal puncturing schemes to said radio blocks transporting repeated bit portions of said real-time data entity.

4. Method according to claim 1, **characterized in that** it further comprises the step of selecting a modulation and coding scheme for which the maximum efficient bit rate is higher than the real-time data entity bit rate plus the bit rate due to said repeated bit portions.

5. Method according to claim 1, further comprising the step of defining at least two different redundancy policies according to step i. of claim 1 and modifying the used redundancy policy according to an indicator on the radio link quality.

6. Method according to claim 1 used in an Enhanced Data rate for GSM Evolution EDGE network, said modulation and coding scheme (M ; C) being chosen from the group of modulation and coding schemes defined in EDGE specification, said real-time data entities being compressed voice frames issued by a GSM voice codec.

7. Transmitter (50) adapted to be used for the transmission of real-time data entities on a radio packet communication network, said real time data entities (12N) being generated at said transmitter and comprising at least two bit portions (class A, class B) having different relevance, said real time data entity (12N) being encapsulated in a radio block (13M) and submitted to a modulation and coding scheme (MCS) before transmission, said transmitter (50) being **characterized in that** it comprises:
- means (52, 53) for repeating at least one portion (class A) of said real time data entity (12N) in at least one additional radio block (13M+1).

8. Receiver (60) adapted to be used for the reception of real-time data entities (12N) transmitted on a radio packet communication network, said real time data entities (12N) being generated at said transmitter (50) and comprising at least two bit portions (class A, Class B) having different relevance, said real time data entity (12N) being encapsulated in a radio block (13M) and submitted to a modulation and coding scheme (MCS), said receiver (60) being **characterized in that** it comprises:
- means (64) for extracting different copies of at least one portion (class A) of a real-time data entity (12N) from at least two received radio blocks (13M, 13M+1); and
- means (65) for correcting errors in said at least one bit portion by applying a predefined function to said repeated bit portions received in said at least two radio blocks (13M, 13M+1).
